Europäisches Patentamt

European Patent Office

Office européen des brevets

(19)

(11) EP 1 332 827 A1

## (12) EUROPÄISCHE PATENTANMELDUNG

(43) Veröffentlichungstag:
06.08.2003 Patentblatt 2003/32

(51) Int Cl.$^7$: B23K 20/00

(21) Anmeldenummer: 02002446.9

(22) Anmeldetag: 01.02.2002

(84) Benannte Vertragsstaaten:
AT BE CH CY DE DK ES FI FR GB GR IE IT LI LU
MC NL PT SE TR
Benannte Erstreckungsstaaten:
AL LT LV MK RO SI

(71) Anmelder: Esec Trading S.A.
6330 Cham (CH)

(72) Erfinder:
• Mayer, Michael, Dr.
6345 Neuheim (CH)
• Melzer, Martin
6312 Steinhausen (DE)

(74) Vertreter: Falk, Urs, Dr.
Patentanwaltsbüro Dr. Urs Falk,
Eichholzweg 9A
6312 Steinhausen (CH)

### (54) Verfahren für die Kalibrierung eines Wire Bonders

(57) Um beim Drahtbonden mittels eines Wire Bonders nach einem Kapillarenwechsel optimale Bondresultate zu erzielen, wird vorgeschlagen, nach einem Wechsel von einer ersten Kapillare zu einer zweiten Kapillare den Ultraschallgeber, der das die Kapillare führende Horn mit Ultraschall beaufschlägt, mit einem Parameter $P_2$ zu steuern, der sich aus dem Parameter $P_1$ vor dem Kapillarenwechsel ergibt zu $P_2 = g(k_1, k_2) * P_1$ oder $P_2 = g(k_1, k_2, A_1, A_2) * P_1$ oder $P_2 = g(k_1, k_2, A_1, A_2, H_1, H_2) * P_1$, wobei die Grössen $k_1$ und $k_2$ Schätzwerte für die Biegesteifigkeit, die Grössen $A_1$ und $A_2$ die Amplituden der frei schwingenden Kapillare und $H_1$ und $H_2$ den Durchmesser im engsten Bereich der Längsbohrung der ersten bzw. zweiten Kapillare bezeichnen und wobei die Funktion g eine vorbestimmte Funktion ist.

Fig. 5

**Beschreibung**

Die Erfindung betrifft ein Verfahren für die Kalibrierung eines Wire Bonders der im Oberbegriff des Anspruchs 1 genannten Art.

Ein Wire Bonder ist eine Maschine, mit der Halbleiterchips nach deren Montage auf einem Substrat verdrahtet werden. Der Wire Bonder weist eine Kapillare auf, die an der Spitze eines Horns eingespannt ist. Die Kapillare dient zum Befestigen des Drahtes auf einem Anschlusspunkt des Halbleiterchips und auf einem Anschlusspunkt des Substrates sowie zur Drahtführung zwischen den beiden Anschlusspunkten. Bei der Herstellung der Drahtverbindung zwischen dem Anschlusspunkt des Halbleiterchips und dem Anschlusspunkt des Substrates wird das aus der Kapillare ragende Drahtende zunächst zu einer Kugel geschmolzen. Anschliessend wird die Drahtkugel auf dem Anschlusspunkt des Halbleiterchips mittels Druck und Ultraschall befestigt. Dabei wird das Horn von einem Ultraschallgeber mit Ultraschall beaufschlagt. Diesen Prozess nennt man Ball-bonden. Dann wird der Draht auf die benötigte Drahtlänge durchgezogen, zu einer Drahtbrücke geformt und auf dem Anschlusspunkt des Substrates verschweisst. Diesen letzten Prozessteil nennt man Wedge-bonden. Nach dem Befestigen des Drahtes auf dem Anschlusspunkt des Substrats wird der Draht abgerissen und der nächste Bondzyklus kann beginnen.

Das Ball-bonden wird von verschiedenen Faktoren beeinflusst. Um Bondverbindungen von vorbestimmter Qualität zu erzielen, müssen für einen bestimmten Prozess die optimalen Werte mehrerer physikalischer und/oder technischer Parameter eruiert werden. Beispiele solcher Parameter sind die Bondkraft, das ist die Kraft, die die Kapillare während des Bondvorganges auf den Ball bzw. den Anschlusspunkt des Halbleiterchips ausübt, oder die Amplitude des Wechselstroms, mit dem der Ultraschallgeber des Horns beaufschlagt wird.

Die Abstände zwischen den Abschlusspunkten auf den Halbleiterchips, in der Fachwelt "pitch" genannt, werden zunehmend kleiner. Im Fine Pitch Bereich bewegt man sich heute bereits auf einen pitch von nur noch 50 µm zu. Dies bedeutet, dass auch die Abmessungen der Kapillare im Bereich ihrer Spitze zunehmend kleiner werden, damit die Kapillare nicht in Berührung mit den bereits gebondeten Drähten kommt. Mit den zunehmend kleiner werdenden Abmessungen der Spitze der Kapillare nimmt der Einfluss von unvermeidlichen Herstellungstoleranzen auf die mechanischen Eigenschaften der Kapillare zu. Beim Bonden nützt sich die Kapillare ab, so dass sie von Zeit zu Zeit durch eine neue Kapillare ersetzt werden muss. Um auch im Fine Pitch Bereich zuverlässige Bondresultate zu erzielen, ohne dass der Wire Bonder nach jedem Kapillarenwechsel in zeitaufwendiger Arbeit neu kalibriert werden muss, werden heutzutage die Kapillaren nach strengen geometrischen Kriterien selektioniert.

Der Erfindung liegt die Aufgabe zugrunde, ein Verfahren für die Kalibrierung eines Wire Bonders zu entwikkeln, das gewährleistet, dass Halbleiterchips in der Massenproduktion vor und nach einem Kapillarenwechsel unter den gleichen Prozessbedingungen verdrahtet werden.

Eine weitere Aufgabe, die sich in der Massenproduktion stellt, ist die Übertragung der auf einem Wire Bonder gefundenen optimalen Parameter auf einen anderen Wire Bonder. Die Erfindung soll auch für diese Aufgabe eine Lösung bieten und den Rezepttransfer von Wire Bonder zu Wire Bonder auf einfache und robuste Weise unterstützen.

Die genannten Aufgaben werden gelöst durch die in den Ansprüchen 1, 3 und 5 angegebenen Merkmale.

Jeder Wire Bonder weist eine an einem Horn eingespannte Kapillare auf. Ein Ultraschallgeber beaufschlagt das Horn mit Ultraschall, wobei der Ultraschallgeber mittels eines Parameters P gesteuert wird. Der Parameter P ist vorzugsweise der Strom, der durch den Ultraschallgeber fliesst. Der Parameter P kann aber auch die Amplitude der an den Ultraschallgeber angelegten Wechselspannung oder der Leistung oder eine andere Grösse sein, die den Ultraschallgeber steuert.

Beim Kapillarenwechsel ändert sich in der Regel das Schwingungsverhalten der Kapillarenspitze, weil jede Kapillare etwas andere Eigenschaften aufweist und auch etwas anders im Horn eingespannt ist. Das für die Lösung der genannten Aufgaben angestrebte Ziel liegt darin, die wesentlichen Einflussgrössen der Kapillare bzw. des aus Horn und Kapillare gebildeten Schwingungssystems, die einen massgebenden Einfluss auf den Bondvorgang ausüben, zu messen und die gewonnenen Erkenntnisse dazu zu verwenden, die relevanten Bondparameter des Wire Bonders nach einem Kapillarenwechsel gemäss den mechanischen Eigenschaften der neuen Kapillare neu einzustellen und erst dann die Produktion mit der neuen Kapillare aufzunehmen.

Der Erfindung liegt die Erkenntnis zugrunde, dass die mechanischen Eigenschaften der Spitze der Kapillare einen starken Einfluss auf die Ultraschallkraft haben, die die Kapillare auf die Bondkugel ausübt. Da nämlich die Abmessungen der Kapillare im Bereich der Spitze kleiner und kleiner werden, bewirken unvermeidliche Herstellungstoleranzen auch zunehmende Variationen der Steifigkeit von Kapillare zu Kapillare. Die Erfindung liefert eine Lösung, wie diese Variationen der Steifigkeit kompensiert werden können.

Beim Bonden wird die Kapillare mit einer vorbestimmten Bondkraft beaufschlagt. Die Spitze der Kapillare drückt also in vertikaler Richtung gegen die Bondkugel, die zwischen der Kapillare und dem Anschlusspunkt des Substrates eingeklemmt ist. Wenn das Horn mit Ultraschall beaufschlagt wird, dann bilden sich im Horn und in der Kapillare stehende Ultraschallwellen aus. Da die Kapillare gegen die Bondkugel gedrückt wird, kann ihre Spitze nicht frei schwingen. Die Spitze der Kapillare übt daher eine in horizontaler Richtung gerichtete Kraft, eine sogenannte Tangentialkraft

$F_T$, auf die Bondkugel aus. Diese Tangentialkraft $F_T$ ist eine Funktion der Auslenkung $A_H(t)$ der Hornspitze gegenüber der Spitze der Kapillare, wobei der Parameter t die Zeit bezeichnet. Die Tangentialkraft $F_T(t)$ ist eine wechselförmige Kraft $F_T(t) = F_{T0}*\cos(\omega t)$, die mit der Frequenz $\omega$ der Ultraschallwellen oszilliert.

Die Amplitude $A_H$ der Schwingungen des Horns am Einspannpunkt der Kapillare in Bezug auf die Spitze der Kapillare liegt typischerweise im Bereich von 0.1 - 4 μm und ist damit klein im Verhältnis zur Länge der Kapillare von typisch 11 Millimetern. Die Amplitude $A_H$ ist auch klein im Verhältnis zur Länge des dünnsten Teils der Kapillare, nämlich der Verjüngung an der Spitze der Kapillare. Die Kapillare verhält sich deshalb angenähert wie eine Feder, d.h. die Amplitude $F_{T0}$ der Tangentialkraft $F_T(t)$ ist in guter Näherung proportional zur Amplitude $A_H$ der Schwingungen des Horns am Einspannpunkt der Kapillare in Bezug auf die Spitze der Kapillare:

$$F_{T0} = k * A_H, \tag{1}$$

wobei die Grösse k eine Konstante bezeichnet, die von den mechanischen Eigenschaften der Kapillare abhängt: Die Konstante k ist ein Mass für die Biegesteifigkeit der Kapillare. Die Amplitude $F_{T0}$ der Tangentialkraft hängt somit im wesentlichen von zwei Grössen ab, nämlich von der Amplitude $A_H$, die durch den Ultraschallgeber gesteuert wird, und von der Biegesteifigkeit der Kapillare.

Die Lösung der genannten Aufgaben besteht nun darin, für jede Kapillare deren Biegesteifigkeit zu ermitteln und den Parameter P, der den Ultraschallgeber steuert, nach jedem Kapillarenwechsel der ermittelten Biegesteifigkeit der Kapillare anzupassen, so dass die von der jeweiligen Kapillare auf die Bondkugel ausgeübte Tangentialkraft vor und nach einem Kapillarenwechsel gleich gross ist.

Beim Einrichten für das Bonden eines neuen Produktes müssen zunächst die optimalen Werte für verschiedene Parameter wie Bondkraft, Parameter P für die Steuerung des Ultraschallgebers, etc. ermittelt werden. Im folgenden wird erläutert, wie der Parameter P für die Steuerung des Ultraschallgebers nach einem Kapillarenwechsel neu eingestellt wird. Der Parameter P ist beispielsweise die Amplitude $I_0$ des Wechselstroms I, mit dem der Ultraschallgeber beaufschlagt wird. Zwischen der Amplitude $A_H$ und der Amplitude $I_0$ des Wechselstroms besteht eine lineare Beziehung: $A_H = \alpha * I_0$, wobei die Grösse $\alpha$ eine vom Wire Bonder abhängige Konstante ist und beispielsweise durch eine Kalibration gemäss dem im europäischen Patent EP 498 936 angegebenen Verfahren bestimmt werden kann. Unter der Voraussetzung, dass die Einspannung der Kapillare im Horn keinen oder hur einen geringen Einfluss auf die Grösse $A_H$ hat, ergibt sich die Amplitude $F_{T0}$ der Tangentialkraft also zu

$$F_{T0} = k * A_H = k * \alpha * I_0. \tag{2}$$

Die vom Wire Bonder erzeugte Amplitude der Tangentialkraft $F_T$ ist also vor und nach einem Wechsel von einer ersten Kapillare, deren Biegesteifigkeit durch den Wert $k_1$ charakterisiert wird, zu einer zweiten Kapillare, deren Biegesteifigkeit durch den Wert $k_2$ charakterisiert wird, abgesehen von Einflüssen der Einspannung der Kapillare im Horn, die gleiche, wenn der Wire Bonder nach dem Kapillarenwechsel mit dem Wert

$$P_2 = I_{0,2} = k_1/k_2 * I_{0,1} = k_1/k_2 * P_1 \tag{3}$$

betrieben wird. Da bei dieser Korrektur nur das Verhältnis $k_1/k_2$ eingeht, genügt es, wenn die Biegesteifigkeit nicht absolut, sondern nur bis auf eine Proportionalitätskonstante bekannt ist.

Aus der Gleichung (1) ist ersichtlich, dass neben der Biegesteifigkeit der jeweiligen Kapillare auch die Amplitude $A_H$ der Schwingungen des Horns am Einspannpunkt der Kapillare in Bezug auf die Spitze der Kapillare die auf die Bondkugel ausgeübte Tangentialkraft beeinflusst. Um auch die Einflüsse der Einspannung der jeweiligen Kapillare am Horn sowie den von Einspannung zu Einspannung variierenden Abstand L der Spitze der Kapillare vom Einspannpunkt am Horn auszukorrigieren, wird die Amplitude des durch den Ultraschallgeber fliessenden Wechselstromes bevorzugt auch entsprechend der Amplitude $A_H$ korrigiert. Es wird also in diesem Fall für die erste Kapillare einerseits die Biegesteifigkeit $k_1$ ermittelt und andererseits die Amplitude $A_{H1}$ der Schwingungen des Horns in Bezug auf die Spitze der ersten Kapillare gemessen. Analog wird für die zweite Kapillare die Biegesteifigkeit $k_2$ und die entsprechende Amplitude $A_{H2}$ ermittelt. Der Ultraschallgeber wird dann nach dem Kapillarenwechsel mit dem Parameter $P_2$ beaufschlagt, der gegeben ist durch:

$$P_2 = I_{0,2} = k_1/k_2 * A_{H1}/A_{H2} * I_{0,1} = k_1/k_2 * A_{H1}/A_{H2} * P_1. \tag{4}$$

Die Messung der Amplitude $A_H$ während des Bondvorganges ist relativ aufwendig, da die Bondkugel während des Bondens relativ bald auf dem Anschlusspunkt hin und her zu rutschen beginnt. Es hat sich aber gezeigt, dass anstelle der Amplitude $A_H$ die Amplitude $A_C$ der Schwingungen der Kapillare im Bereich unterhalb des Einspannpunktes am Horn oder die Amplitude $A_S$ der Spitze der Kapillare verwendet werden kann, während die Kapillare frei in der Luft schwingt. Man erhält dann für den Parameter $P_2$:

$$P_2 = k_1/k_2 * A_{C1}/A_{C2} * P_1 \text{ bzw.} \tag{5}$$

$$P_2 = k_1/k_2 * A_{S1}/A_{S2} * P_1, \tag{6}$$

wobei die Grössen $A_{C1}$ und $A_{S1}$ die entsprechenden Amplituden vor dem Kapillarenwechsel und die Grössen $A_{C2}$ und $A_{S2}$ die entsprechenden Amplituden nach dem Kapillarenwechsel bezeichnen. Wichtig ist natürlich, dass die Messung dieser Amplituden bei der Kapillare an der gleichen Stelle erfolgt. Verfahren zur Messung der Amplitude der frei schwingenden Kapillare sind aus dem europäischen Patent EP 498 936 und aus der japanischen Patentanmeldung JP 10-209199 bekannt. Allerdings gehen diese Schriften davon aus, dass die Schwingungen der Kapillare parallel zur Längsrichtung des Horns verlaufen. Dies ist jedoch nicht immer der Fall: Die Amplitude der Schwingungen der Kapillare in einer zur Längsrichtung orthogonalen horizontalen Richtung kann bis zu 30% der Amplitude der Schwingungen der Kapillare parallel zur Längsrichtung des Horns betragen. Bei der Messung ist deshalb darauf zu achten, dass die tatsächliche Amplitude der Schwingungen der Kapillare und nicht nur eine Komponente davon gemessen wird.

Wenn als Amplitude $A(W_1)$ eine der Amplituden $A_{H1}$, $A_{C1}$ oder $A_{S1}$ gemessen wird, dann lässt sich die Erfindung auch für den Rezepttransfer von einem ersten Wire Bonder $W_1$ auf einen zweiten Wire Bonder $W_2$ verwenden. Die Biegesteifigkeiten $k_1$ und $k_2$ der verwendeten Kapillaren werden wie oben erläutert ermittelt. Zudem wird auf dem ersten Wire Bonder $W_1$ die Amplitude $A(W_1)$ der Kapillare ermittelt, wenn der Ultraschallgeber mit einem vorbestimmten Wert $P_0$ des Parameters P beaufschlagt wird. Der Wert $P(W_1)$ bezeichnet den Wert des Parameters P, mit dem der Ultraschallgeber des ersten Wire Bonders $W_1$ bei dem eingerichteten Bondprozess beaufschlagt wird. Auf dem zweiten Wire Bonder $W_2$ wird die entsprechende Amplitude $A_{H2}$, $A_{C2}$ oder $A_{S2}$ als Amplitude $A(W_2)$ der Kapillare ermittelt, wenn der Ultraschallgeber des zweiten Wire Bonders mit dem Wert $P_0$ des Parameters P beaufschlagt wird. Der zweite Wire Bonder $W_2$ wird dann mit dem Wert $P(W_2)$ des Parameters P betrieben, der gegeben ist durch $P(W_2) = k_1/k_2 * A(W_1)/A(W_2) * P(W_1)$. Dabei bezeichnet der Wert $P(W_1)$ den Wert des Parameters P, mit dem der Ultraschallgeber des ersten Wire Bonders $W_1$ bei dem eingerichteten Bondprozess beaufschlagt wird.

Es hat sich nun gezeigt, dass eine weitere geometrische Grösse einen Einfluss auf die Tangentialkraft ausübt, nämlich der Durchmesser der den Draht führenden Längsbohrung der Kapillare im Bereich der Spitze. Die Längsbohrung der Kapillare weist im unteren Bereich einen konstanten Durchmesser H auf, der sich bei der Austrittsöffnung aus für die vorliegende Erfindung unwesentlichen Gründen aufweitet. Da beim Bonden nur der ausserhalb, nicht aber der innerhalb der Längsbohrung sich befindende Teil der Bondkugel deformiert wird, nimmt der Anteil des deformierten Teils der Bondkugel mit zunehmendem Durchmesser H der Längsbohrung ab. Der Ultraschallgeber wird deshalb nach einem Kapillarenwechsel vorteilhaft mit dem Parameter $P_2$ beaufschlagt, der gegeben ist durch:

$$P_2 = k_1/k_2 * A_1/A_2 * H_1{}^2/H_2{}^2 * P_1, \tag{7}$$

wobei $k_1$ die Biegesteifigkeit, $A_1$ eine der oben erwähnten Amplituden $A_{H1}$, $A_{C1}$ oder $A_{S1}$ der frei schwingenden Kapillare und $H_1$ den Durchmesser der Längsbohrung der Kapillare vor dem Kapillarenwechsel und $k_2$, $A_2$ und $H_2$ die entsprechenden Werte der Kapillare nach dem Kapillarenwechsel bezeichnen.

Die vorhin erläuterten Korrekturfaktoren haben sich in der Praxis bewährt. Allerdings gibt es auch Fälle, wo die Korrekturfaktoren eine allgemeinere Abhängigkeit aufweisen, so dass der Ultraschallgeber nach dem Kapillarenwechsel mit dem Paramter $P_2$ beaufschlagt wird, der entsprechend dem Modell gegeben ist durch:

$$P_2 = g(k_1, k_2) * P_1 \tag{8},$$

bzw.

$$P_2 = g(k_1, k_2, A_1, A_2) * P_1 \tag{9},$$

bzw.

$$P_2 = g(k_1, k_2, A_1, A_2, H_1, H_2) * P_1 \tag{10}.$$

Nachfolgend werden anhand der Figuren verschiedene Verfahren erläutert, mit denen die Biegesteifigkeit oder ein Schätzwert für die Biegesteifigkeit durch eine Messung ermittelt oder aufgrund von individuell gemessenen geometrischen Daten der Kapillare und Materialparametern rechnerisch ermittelt wird.

Es zeigen:

Fig. 1, 2      einen in einem Halbleiterchip integrierten Sensor, der aus vier piezoresistiven Elementen besteht,
Fig. 3         die elektrische Beschaltung der vier piezoresistiven Elemente,
Fig. 4         einen weiteren piezoresistiven Sensor, und
Fig. 5         eine Kapillare im Querschnitt.

Eine Möglichkeit, die Biegesteifigkeit durch eine Messung zu ermitteln, besteht darin, die von der Kapillare bei Beaufschlagung mit Ultraschall erzeugte Tangentialkraft mit einem piezoresistiven Sensor zu messen. Aus dem Artikel "Analysis of ultrasonic wire bonding by in-situ piezoresistive microsensors", der in den Proceedings der vom 10.-14. Juni 2001 in München durchgeführten Konferenz "Transducers '01 Eurosensors XV" veröffentlicht wurde, ist ein für diesen Zweck geeigneter piezoresistiver Sensor bekannt.

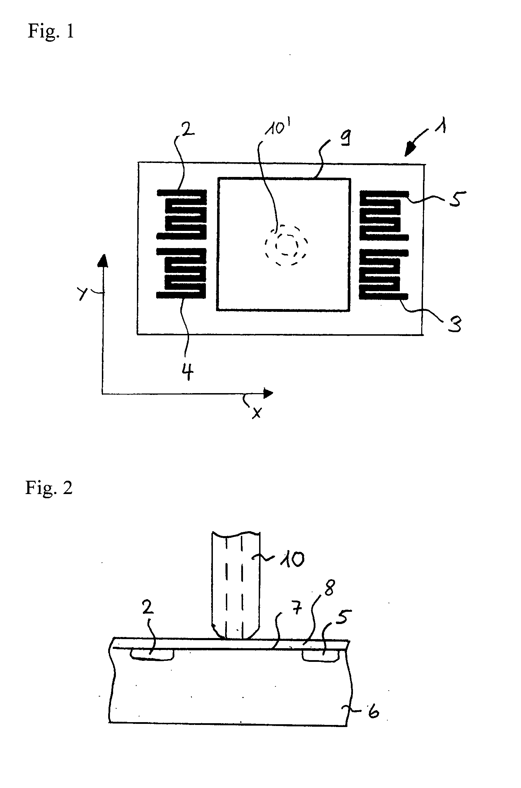

Die Fig. 1 und 2 zeigen in der Aufsicht bzw. im Querschnitt einen in einem Halbleiterchip integrierten Sensor 1, der aus vier piezoresistiven Elementen 2 bis 5 besteht, die elektrisch zu einer Wheatstone Brücke geschaltet sind. Das Ausgangssignal des Sensors 1 entspricht dem Ausgangssignal der Wheatstone Brücke. Der Sensor 1 besteht vorzugsweise aus n-dotiertem Silizium 6, in dessen einer Oberfläche 7 die piezoresistiven Elemente 2 bis 5 als mäanderförmige Widerstandsbahnen aus p-dotiertem Silizium eingebettet sind. Die Oberfläche 7 des Sensors 1 ist mit einer herkömmlichen Passivierungsschicht 8 bedeckt. Die piezoresistiven Elemente 2 bis 5 sind ausserhalb eines beispielsweise quadratischen Kontaktbereiches 9 angeordnet, innerhalb dessen die Spitze der Kapillare 10 eines Wire Bonders bei der Kalibrierung der Ultraschallleistung auf den Halbleiterchip drückt. Der Bereich, wo die Spitze der Kapillare 10 im Idealfall auf den Sensor 1 drückt, ist mit einem gestrichelten kreisförmigen Ring 10' dargestellt. In der Fig. 1 sind die Achsen eines kartesischen Koordinatensystems mit x und y bezeichnet. Die x-Richtung verläuft vorzugsweise parallel zu einer [110] Achse des Siliziumkristalls. Die mäanderförmigen Bahnen der piezoresistiven Elemente 2 bis 5 verlaufen in x-Richtung und sind, in x-Richtung gesehen, links und rechts ausserhalb des Kontaktbereiches 9 angeordnet. Sie dienen zur Erfassung der mechanischen Spannungen, die von der Scherkraft $F_x$ verursacht werden, welche von der Kapillare 10 bei Beaufschlagung mit Ultraschall im Sensor 1 in x-Richtung induziert wird. Bei der Messung ist der Sensor 1 bezüglich des Wire Bonders so zu orientieren, dass die Schwingungsrichtung der Kapillare 10 möglichst parallel zur x-Richtung verläuft.

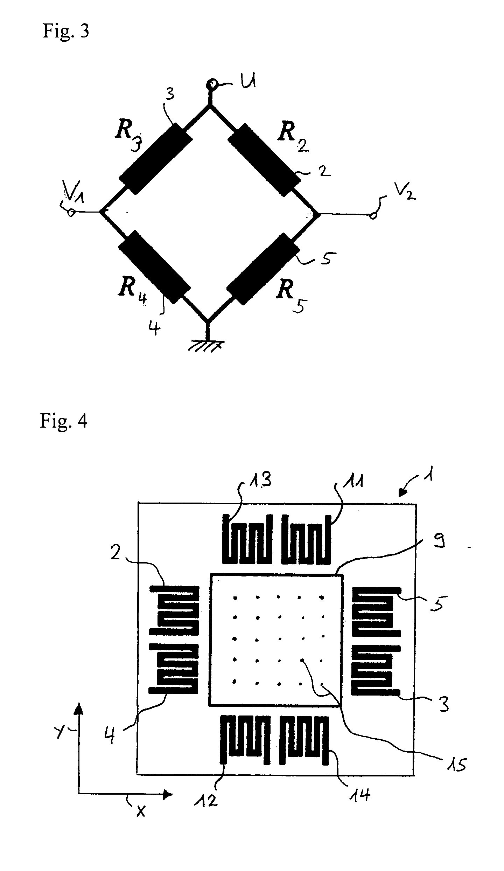

Die Fig. 3 zeigt das elektrische Schaltbild der aus den vier piezoresistiven Elementen 2 bis 5 gebildeten Wheatstone Brücke. Die vier piezoresistiven Elemente 2 bis 5 sind über gewöhnliche Leiterbahnen aus Aluminium verdrahtet. Die Wheatstone Brücke wird vorzugsweise aus einer Konstantspannungsquelle mit einer Spannung U gespeist. Die Ausgangsspannung $U_{Out} = V_1 - V_2$ der Wheatstone Brücke ergibt sich dann zu

$$U_{Out} = \frac{R_2 R_4 - R_3 R_5}{(R_3 + R_4) * (R_2 + R_5)} \, U \tag{11},$$

wobei $R_2$ bis $R_5$ die ohmschen Widerstände der piezoresistiven Elemente 2 bis 5 bezeichnen.

Die Biegesteifigkeit der Kapillare wird nun mittels eines Wire Bonders gemäss dem folgenden Verfahren bestimmt:

    1. Die Kapillare wird, ohne Draht bzw. ohne Drahtkugel, auf den Kontaktbereich 9 des Sensors 1 aufgesetzt. Die Kapillare soll möglichst in der Mitte des Kontaktbereiches 9 aufgesetzt werden.

    2. Die Kapillare wird mit einer Bondkraft $F_C$ beaufschlagt, die so gross ist, dass die Kapillare beim nächsten Schritt 3 auf der Oberfläche des Sensors 1 nicht hin und her rutscht. Bewährt hat sich eine Bondkraft von 1N.

    3. Der Ultraschallgeber wird mit einem vorbestimmten Wert des Parameters P, beispielsweise mit dem bei dem laufenden Produktionsprozess benutzen Wert, beaufschlagt. Dann wird gewartet, bis der Einschwingvorgang abgeschlossen und ein stationärer Zustand erreicht ist. Dieser stationäre Zustand ist dadurch charakterisiert, dass die Amplitude $U_0$ des Sensorsignals $U_{Out}(t)$ nicht mehr ändert. Die Amplitude $U_0$ wird als Referenzwert $U_{Ref}$ ge-

speichert:

$$U_{Ref} = U_0 \qquad (12).$$

4. Die Kapillare wird vom Sensor 1 abgehoben und es wird als Amplitude A eine der vorgängig beschriebenen Amplituden $A_C$ oder $A_S$ bestimmt, während die Kapillare frei in der Luft schwingt.
5. Die Biegesteifigkeit k der Kapillare wird dann berechnet zu

$$k = U_{Ref}/A \qquad (13).$$

Bei diesem Verfahren wird also davon ausgegangen, dass die von der Kapillare auf die Bondkugel ausgeübte Tangentialkraft proportional zu der mit dem Sensor 1 gemessenen Scherkraft ist. Der mit diesem Verfahren für die Biegesteifigkeit ermittelte Wert k charakterisiert die Biegesteifigkeit der Kapillare allerdings nicht als ein absoluter Wert, sondern nur als ein relativer Wert, d.h. bis auf eine Proportionalitätskonstante. Man kann auch sagen, dass anstelle des genauen Wertes für die Biegesteifigkeit ein Schätzwert für die Biegesteifigkeit bestimmt wird. Unter dem Begriff Schätzwert ist sowohl zu verstehen, dass der Wert für die Biegesteifigkeit nicht absolut genau ist, sondern auch, dass der Schätzwert nur bis auf eine Proportionalitätskonstante bekannt ist.

Die Fig. 4 zeigt in Aufsicht einen Sensor 1, bei dem sich ein Referenzwert $U_{Ref}$ ermitteln lässt, ohne dass der Sensor 1 in Bezug auf die Schwingungsrichtung der Kapillare ausgerichtet werden muss. Der Sensor 1 enthält vier piezoresistive Elemente 2 bis 5 für die Messung der in x-Richtung induzierten Scherkraft $F_x$, und vier weitere piezoresistive Elemente 11 bis 14 für die Messung der in y-Richtung induzierten Scherkraft $F_y$. Die vier piezoresistiven Elemente 2 bis 5 sind elektrisch zu einer ersten Wheatstone Brücke geschaltet, deren Ausgangssignal mit $U_{Out,x}(t)$ bezeichnet wird. Die vier piezoresistiven Elemente 11 bis 14 sind elektrisch zu einer zweiten Wheatstone Brücke geschaltet, deren Ausgangssignal mit $U_{Out,y}(t)$ bezeichnet wird. Mit diesem Sensor 1 lässt sich eine Referenzgrösse $U_{Ref}$ bestimmen, ohne dass die Schwingungsrichtung der Kapillare 10 parallel zur x-Richtung des Sensors 1 ausgerichtet werden muss. Sobald der Einschwingvorgang abgeschlossen und ein stationärer Zustand erreicht ist, wird die Referenzgrösse $U_{Ref}$ aus den Amplituden $U_{0,x}$ und $U_{0,y}$ der Ausgangssignale $U_{Out,x}(t)$ und $U_{Out,y}(t)$ bestimmt zu

$$U_{Ref} = \sqrt{U_{0,x}^2 + U_{0,y}^2} \qquad (14).$$

Die Abmessungen des Kontaktbereiches 9 betragen typischerweise 80μm * 80μm, während der Durchmesser der Spitze der Kapillare 10 etwa 50μm bis 150μm beträgt.

Die Amplituden der Ausgangssignale $U_{Out,x}$ und $U_{Out,y}$ sind abhängig von der Position, wo die Kapillare 10 auf den Kontaktbereich 9 drückt. Zur Erhöhung der Genauigkeit der Kalibrierung wird deshalb vorgeschlagen, die Kapillare 10 an verschiedenen Stellen auf den Kontaktbereich 9 abzusetzen und die Referenzgrösse $U_{Ref}$ und den Korrekturfaktor γ aufgrund der an diesen Stellen erhaltenen Messwerte zu bestimmen, z.B. folgendermassen:

In der Fig. 4 sind schematisch die mittleren Aufsetzpunkte 15 der Kapillare 10 gezeigt, denen je ein Koordinatenpaar $(x_{i,k}, y_{i,k})$ zugeordnet ist, wobei die Indices i und k im Beispiel je fünf verschiedene Werte annehmen. Der Abstand zwischen zwei Aufsetzpunkten 15 beträgt typisch 5μm bis 10μm. Die gemäss einem der vorstehend beschriebenen Verfahren gemessenen Amplituden $U_{0,x}(x_{i,k}, y_{i,k})$ und, gegebenenfalls $U_{0,y}(x_{i,k}, y_{i,k})$, formen je eine Fläche mit einem Sattel. Es werden nun die Koordinaten des Sattels $(x_{S,x}, y_{S,x})$ der Funktion $U_{0,x}$ und dann der Wert $U_{0,x}(x_{S,x}, y_{S,x})$ sowie, gegebenenfalls, die Koordinaten des Sattels $(x_{S,y}, y_{S,y})$ der Funktion $U_{0,y}$ und dann der Wert $U_{0,y}(x_{S,y}, y_{S,y})$ rechnerisch bestimmt und schliesslich der Referenzwert $U_{Ref}$ gemäss Gleichung (12) bzw. (14) berechnet.

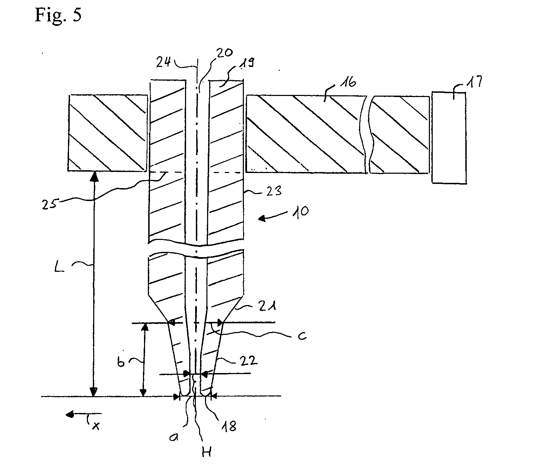

Eine andere Möglichkeit besteht darin, die für die Biegesteifigkeit relevanten geometrischen Daten der Kapillare auszumessen und daraus unter Berücksichtigung von Materialparametern wie Elastizitätsmodul, Dichte und Dämpfungskoeffizient für die innere Reibung des Kapillarenmaterials bei der beim Bonden benützen Frequenz des Ultraschalls mittels eines Simulationsprogramms die Biegesteifigkeit bzw. einen Schätzwert für die Biegesteifigkeit zu berechnen. Nachfolgend wird am Beispiel der in der Fig. 5 gezeigten Kapillare erläutert, wie ein Schätzwert für die Biegesteifigkeit der Kapillare ermittelt werden kann.

Die Fig. 5 zeigt im Querschnitt eine Kapillare 10, die in einem Horn 16 eines Wire Bonders eingespannt ist. Das Horn 16 wird von einem Ultraschallgeber 17 mit Ultraschall beaufschlagt. Der Ultraschallgeber 17 besteht in der Regel aus piezoelektrischen Keramiken. Der Ultraschallgeber 17 wird bevorzugt mit einem Wechselstrom $I = I_0 * \cos(\omega t)$ gespeist, dessen Frequenz ω einer Eigenfrequenz des aus Kapillare und Horn gebildeten Schwingungssystems entspricht und dessen Amplitude $I_0$ auf den Bondprozess abgestimmt ist.

In der Figur bezeichnet L den Abstand der Spitze 18 der Kapillare vom Einspannpunkt am Horn, der von Einspannung zu Einspannung um typisch bis zu 100 µm variiert.

Die Kapillare 10 besteht aus einem länglichen Körper 19 mit einer gegen die Austrittsöffnung verjüngten Längsbohrung 20 zur Aufnahme eines nicht dargestellten Bonddrahtes. Der Körper 19 ist gegen die Spitze 18 der Kapillare 10 in einer oder, wie dargestellt, in zwei Stufen 21 und 22 verjüngt. Der Körper 19 besteht somit aus einem Schaft 23 und den zwei Verjüngungsstufen 21 und 22. Die zweite Stufe 22 wird in der Fachwelt allgemein als "bottle neck" bezeichnet. Die Wandstärke der Kapillare 10 ist im Bereich des bottle necks am kleinsten, weshalb sich Schwankungen der Geometrie der Kapillare 10 im Bereich des bottle necks naturgemäss am stärksten auf die Biegesteifigkeit auswirken. Es ist nun so, dass sich Schwankungen der äusseren Abmessungen viel stärker auf die Biegesteifigkeit auswirken als Schwankungen des Innendurchmessers der Längsbohrung 20. Ein relativ guter Schätzwert für die Biegesteifigkeit der Kapillare 10 lässt sich deshalb bereits dann ermitteln, wenn nur die äusseren Abmessungen des bottle necks berücksichtigt werden. Zudem erweist sich die Annahme, dass die Kapillare 10 rotationssymmetrisch bezüglich ihrer Längsachse 24 ist, in vielen Fällen als begründet und ausreichend genau für die Ermittlung der Biegesteifigkeit.

Im Beispiel wird die Aussengeometrie des bottle necks als rotationssymmetrisch und als trapezförmig angenommen. Sie ist dann charakterisiert durch die drei Längen a, b und c. Die Längen a, b und c werden mit einer geeigneten Messmethode, z.B. optisch, bestimmt. Die Geometrie des Schafts 23 und der ersten Verjüngungsstufe 21 wird als konstant vorausgesetzt, da der Einfluss von Schwankungen dieser beiden Teile auf die Biegesteifigkeit in guter Näherung unbedeutend ist. Auch die Geometrie der Längsbohrung 20 wird als konstant vorausgesetzt, da ihr Einfluss auf die Biegesteifigkeit viel geringer als der Einfluss der Aussengeometrie ist.

Die Biegesteifigkeit $k_B$ ist definiert durch die Kraft F, die nötig ist, um die Spitze 18 der Kapillare 10 senkrecht zu ihrer Längsachse 24 in einer als x-Richtung bezeichneten Richtung um eine vorbestimmte Distanz $x_0$ von typisch 1 bis 2 µm auszulenken:

$$F = - k_B * x_0.$$

Die Distanz $x_0$ entspricht der Amplitude der Schwingungen des Horns 16 am Einspannpunkt der Kapillare 10 in Bezug auf die Spitze der Kapillare 10.

Die Biegesteifigkeit $k_B$ wird ermittelt unter Berücksichtigung von Materialparametern der Kapillare 10 wie Elastizitätsmodul E, Dichte ρ und Dämpfungskoeffizient γ(ω) für die innere Reibung des Kapillarenmaterials bei der beim Bonden benützten Frequenz ω des Ultraschalls. Dies erfolgt beispielsweise mittels eines nach der Methode der Finiten Elemente arbeitenden Simulationsprogramms, das mindestens die Aussengeometrie der zweiten Verjüngungsstufe 22, des bottle necks, im Beispiel der als rotationssymmetrisch und im Querschnitt als trapezförmig angenommenen zweiten Verjüngungsstufe 22 der Kapillare, also die drei geometrischen Parameter a, b und c, sowie die Materialparameter Elastizitätsmodul E, Dichte ρ und Dämpfungskoeffizient γ(ω) berücksichtigt. Die Geometrie der Längsbohrung 20 wird als konstant vorausgesetzt. Die Geometrie ihrer Austrittsöffnung an der Spitze 18 der Kapillare 10 wird entweder als konstant angesehen oder individuell für jede Kapillare 10 ausgemessen und bei der Simulation berücksichtigt.

Bevorzugt wird bei der Ermittlung des Schätzwertes k mit Hilfe des Simulationsprogramms auch die Geometrie der ersten Verjüngungsstufe 21 und des Schaftes 23 berücksichtigt, allerdings können diese Geometrien in der Regel als konstant vorausgesetzt werden, da diese Teile viel steifer als die zweite Verjüngungsstufe 22 sind. Der derart ermittelte Wert für die Biegesteifigkeit $k_B$ stellt nicht die tatsächliche Biegesteifigkeit dar, sondern einen Schätzwert k.

Bevorzugt wird für die Simulation ein dynamisches Modell verwendet, bei dem die Grenzkante 25 zu Schwingungen in x-Richtung angeregt wird. Zudem wird bevorzugt auch ein durch die Auslenkung der Grenzkante 25 induziertes Drehmoment berücksichtigt. Möglich ist aber auch die Verwendung eines statischen Modells, bei dem die Grenzkante 25 in x-Richtung um eine Distanz von typisch 2 µm in x-Richtung ausgelenkt wird. Sowohl beim dynamischen wie beim statischen Modell wird die an der Spitze 18 der Kapillare in x-Richtung gerichtete Kraft berechnet. Die Simulation berücksichtigt also die mechanischen Eigenschaften der Kapillare von ihrer Spitze bis zu dem durch die Grenzkante 25 dargestellten Einspannpunkt am Horn 16.

Im Handel sind auch Kapillaren mit einer anderen Geometrie erhältlich. In diesem Fall ist für die rechnerische Ermittlung der Biegesteifigkeit mittels eines Simulationsprogramms die Geometrie der Spitze der Kapillare durch geeignete Parameter zu beschreiben und diese bei jeder Kapillare für die Simulation auszumessen.

Aus der Fig. 5 ist auch ersichtlich, dass die Längsbohrung 20 der Kapillare 10 im unteren Bereich der zweiten Verjüngungsstufe 22 einen konstanten Durchmesser H aufweist, der sich bei der Austrittsöffnung aus für die vorliegende Erfindung unwesentlichen Gründen aufweitet. Wenn der Durchmesser H für jede Kapillare individuell bestimmt wird, lässt sich der Ultraschallparameter P nach einem Kapillarenwechsel wie weiter oben erläutert gemäss der Gleichung (6) anpassen.

**Patentansprüche**

1. Verfahren für die Kalibrierung eines Wire Bonders nach einem Wechsel von einer ersten Kapillare zu einer zweiten Kapillare, wobei die erste bzw. zweite Kapillare an der Spitze eines von einem Ultraschallgeber mit Ultraschall beaufschlagbaren Hornes eingespannt ist, wobei der Ultraschallgeber beim Betrieb mit der ersten Kapillare mit einem Wert $P_1$ eines Parameters P gesteuert wird und wobei der Ultraschallgeber beim Betrieb mit der zweiten Kapillare mit einem Wert $P_2$ des Parameters P gesteuert wird, **dadurch gekennzeichnet, dass** ein Schätzwert $k_1$ für die Biegesteifigkeit der ersten Kapillare und ein Schätzwert $k_2$ für die Biegesteifigkeit der zweiten Kapillare ermittelt wird, und dass der Wert $P_2$ eingestellt wird zu $P_2 = g(k_1, k_2) * P_1$, wobei $g(k_1, k_2)$ eine vorbestimmte Funktion der beiden Schätzwerte $k_1$ und $k_2$ ist.

2. Verfahren nach Anspruch 1, **dadurch gekennzeichnet, dass** die Funktion $g(k_1, k_2)$ gegeben ist durch $g(k_1, k_2) = k_1/k_2$.

3. Verfahren für die Kalibrierung eines Wire Bonders nach einem Wechsel von einer ersten Kapillare zu einer zweiten Kapillare, wobei die erste bzw. zweite Kapillare an der Spitze eines von einem Ultraschallgeber mit Ultraschall beaufschlagbaren Hornes eingespannt ist, wobei der Ultraschallgeber beim Betrieb mit der ersten Kapillare mit einem Wert $P_1$ eines Parameters P gesteuert wird und wobei der Ultraschallgeber beim Betrieb mit der zweiten Kapillare mit einem Wert $P_2$ des Parameters P gesteuert wird, **dadurch gekennzeichnet, dass** ein Schätzwert $k_1$ für die Biegesteifigkeit der ersten Kapillare und ein Schätzwert $k_2$ für die Biegesteifigkeit der zweiten Kapillare ermittelt wird, dass die Amplitude $A_1$ der Schwingungen der Spitze der ersten Kapillare bestimmt wird, wenn der Ultraschallgeber mit einem vorbestimmten Wert $P_0$ des Parameters P beaufschlagt wird, dass die Amplitude $A_2$ der Schwingungen der Spitze der zweiten Kapillare bestimmt wird, wenn der Ultraschallgeber mit dem Wert $P_0$ des Parameters P beaufschlagt wird, und dass der Wert $P_2$ eingestellt wird zu $P_2 = g(k_1, k_2, A_1, A_2) * P_1$, wobei $g(k_1, k_2, A_1, A_2)$ eine vorbestimmte Funktion der beiden Schätzwerte $k_1$ und $k_2$ und der gemessenen Amplituden $A_1$ und $A_2$ ist.

4. Verfahren nach Anspruch 3, **dadurch gekennzeichnet, dass** die Funktion $g(k_1, k_2, A_1, A_2)$ gegeben ist durch $g(k_1, k_2, A_1, A_2) = k_1/k_2 * A_1/A_2$.

5. Verfahren für die Kalibrierung eines Wire Bonders nach einem Wechsel von einer ersten Kapillare zu einer zweiten Kapillare, wobei die erste bzw. zweite Kapillare an der Spitze eines von einem Ultraschallgeber mit Ultraschall beaufschlagbaren Hornes eingespannt ist, wobei der Ultraschallgeber beim Betrieb mit der ersten Kapillare mit einem Wert $P_1$ eines Parameters P gesteuert wird und wobei der Ultraschallgeber beim Betrieb mit der zweiten Kapillare mit einem Wert $P_2$ des Parameters P gesteuert wird, und wobei die erste und die zweite Kapillare eine Längsbohrung aufweisen, die auf der ihrer Austrittsöffnung zugewandten Seite über eine gewisse Strecke einen konstanten Durchmesser $H_1$ bzw. $H_2$ aufweisen, **dadurch gekennzeichnet, dass** ein Schätzwert $k_1$ für die Biegesteifigkeit der ersten Kapillare und ein Schätzwert $k_2$ für die Biegesteifigkeit der zweiten Kapillare ermittelt wird, dass die Amplitude $A_1$ der Schwingungen der Spitze der ersten Kapillare bestimmt wird, wenn der Ultraschallgeber mit einem vorbestimmten Wert $P_0$ des Parameters P beaufschlagt wird, dass die Amplitude $A_2$ der Schwingungen der Spitze der zweiten Kapillare bestimmt wird, wenn der Ultraschallgeber mit dem Wert $P_0$ des Parameters P beaufschlagt wird, dass der Durchmesser $H_1$ der ersten Kapillare und der Durchmesser $H_2$ der zweiten Kapillare gemessen werden, und dass der Wert $P_2$ eingestellt wird zu $P_2 = g(k_1, k_2, A_1, A_2, H_1, H_2) * P_1$, wobei $g(k_1, k_2, A_1, A_2, H_1, H_2)$ eine vorbestimmte Funktion der beiden Schätzwerte $k_1$ und $k_2$, der gemessenen Amplituden $A_1$ und $A_2$ und der gemessenen Durchmesser $H_1$ und $H_2$ ist.

6. Verfahren nach Anspruch 5, **dadurch gekennzeichnet, dass** die Funktion $g(k_1, k_2, A_1, A_2, H_1, H_2)$ gegeben ist durch $g(k_1, k_2, A_1, A_2, H_1, H_2) = k_1/k_2 * A_1/A_2 * H_1^2/H_2^2$.

7. Verfahren nach einem der Ansprüche 1 bis 6, **dadurch gekennzeichnet, dass** für die Ermittlung der Schätzwerte $k_1$ und $k_2$ mindestens die Aussengeometrie der Spitze der entsprechenden Kapillare ausgemessen wird.

8. Verfahren nach einem der Ansprüche 1 bis 6, **dadurch gekennzeichnet, dass** die Schätzwerte $k_1$ und $k_2$ mit Hilfe eines piezoresistiven Sensors ermittelt werden.

Fig. 1

Fig. 2

Fig. 3

Fig. 4

Fig. 5

<table>
<tr><td>Europäisches<br>Patentamt</td><td>**EUROPÄISCHER RECHERCHENBERICHT**</td><td>Nummer der Anmeldung<br>EP 02 00 2446</td></tr>
</table>

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 5 377 894 A (MIZOGUCHI KIYOSHI ET AL)<br>3. Januar 1995 (1995-01-03)<br>* Spalte 6, Zeile 23-38; Abbildungen 11-13 * | 1-8 | B23K20/00 |
| A | US 2001/045443 A1 (MILLER AMIR ET AL)<br>29. November 2001 (2001-11-29)<br>* Seite 2, Absatz 42 – Seite 3, Absatz 44; Abbildung 2 * | 1-8 | |
| A,D | SCHWIZER, MAYER, BRAND, BALTES: "Analysis of Ultrasonic Wire Bonding gy In-situ Piezoresistive Microsensors"<br>PROCEDINGS OF TRANSDUCER '01 EUROSENSORS XV,<br>10. – 14. Juni 2001, Seiten 1426-1429, XP008002207<br>Munich<br>* das ganze Dokument * | 1-8 | |
| | | | **RECHERCHIERTE SACHGEBIETE (Int.Cl.7)**<br><br>B23K |

Der vorliegende Recherchenbericht wurde für alle Patentansprüche erstellt

| Recherchenort | Abschlußdatum der Recherche | Prüfer |
|---|---|---|
| DEN HAAG | 22. Mai 2002 | Jaeger, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
......................................................................
& : Mitglied der gleichen Patentfamilie, übereinstimmendes Dokument

EPO FORM 1503 03.82 (P04C03)

**EP 1 332 827 A1**

## ANHANG ZUM EUROPÄISCHEN RECHERCHENBERICHT
## ÜBER DIE EUROPÄISCHE PATENTANMELDUNG NR.

EP 02 00 2446

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-05-2002

| Im Recherchenbericht angeführtes Patentdokument | | Datum der Veröffentlichung | Mitglied(er) der Patentfamilie | | Datum der Veröffentlichung |
|---|---|---|---|---|---|
| US 5377894 | A | 03-01-1995 | JP | 2527399 B2 | 21-08-1996 |
| | | | JP | 6112281 A | 22-04-1994 |
| US 2001045443 | A1 | 29-11-2001 | US | 6321969 B1 | 27-11-2001 |
| | | | US | 2002033408 A1 | 21-03-2002 |
| | | | EP | 1189722 A1 | 27-03-2002 |
| | | | WO | 0183152 A1 | 08-11-2001 |

EPO FORM P0461

Für nähere Einzelheiten zu diesem Anhang : siehe Amtsblatt des Europäischen Patentamts, Nr.12/82